# EUROPEAN PATENT APPLICATION

(11) **EP 4 640 994 A2**
(43) Date of publication of application: **29.10.2025**
(21) Application number: 25201339.6
(22) Date of filing: 31.01.2025
(51) Int. Cl.: F01D 25/28

(54) **TOOLING AND METHOD FOR MASKING A TURBINE COMPONENT SUCH AS A BLADE OR VANE**

(30) Priority: 01.02.2024 US 202418430364
(62) Divisional of application: 25155381.4
(71) Applicant: Chromalloy Gas Turbine LLC, Palm Beach Gardens, Florida 33410 (US)
(72) Inventor: BURDEN, Brendan Robert, Palm Beach Gardens, 33410 (US); MRAVCAK, Paul, Palm Beach Gardens, 33410 (US); HOPKINS, Zachary Charles, Palm Beach Gardens, 33410 (US); ORAS, Zachary Michael Au Kanai'i, Palm Beach Gardens, 33410 (US)
(74) Representative: Whitfield, Jack Stephen

(57) **Abstract**

A method of loading a turbine component into a masking tool for a protective coating system is provided comprising separating or partially separating casing parts of the masking tool to open access to a holding chamber of the masking tool and inserting the turbine component into the chamber; and securing together the casing parts of the masking tool to create a tight fit between the casing parts of the masking tool and the turbine component that is substantially impermeable to the protective coating. The turbine component remains uncovered after the casing parts of the masking tool are secured together. The interior surfaces of the casing parts are contoured to match a contour of the turbine component so that at least a part of the turbine component abuts against the one or more contoured interior surfaces.

## Description

### TECHNICAL FIELD

The technology relates to tooling used during the manufacturing or servicing of turbine components, such as blades or vanes for a gas turbine. In particular, the technology relates to a masking tool for holding a gas turbine component during a process to coat the component.

### BACKGROUND

Turbine components, such as a turbine blades (also referred to as airfoils) or vanes , in a gas turbine are typically subjected to stress from centrifugal force and fluid forces that can cause fracture, yielding, or creep failures. In addition, turbine components often endure temperatures around 2,500 °F (1,370 °C). Such high temperatures can weaken the turbine components and make them more susceptible to creep and corrosion failures. Also, vibrations from the turbine itself can cause fatigue failures.

One solution employed to improve the durability of and protect turbine components is to add a protective coating to component surfaces. For example, thermal barrier coatings, such as high temperature corrosion resistant metallic coatings.

Conventional coating processes may prepare the turbine components by attaching casing parts of sheet metal to the turbine components to mask the portions of the turbine components from the protective coating material. The sheet metal is positioned to mask the portions of the turbine components that are not intended to be coated by the coating material. Because the sheet metal is not shaped to conform to the shape of the turbine component, gaps may exist between the sheet metal and the turbine component. Gaps may also exist between the different casing parts of sheet metal. Coating material may seep through the gaps and coat the portions of the turbine components that are not intended to be coated.

A masking system is desired that better masks the turbine components to prevent undesired seepage of the coating material during the coating process.

### SUMMARY

Disclosed herein are systems and methods that may be applied to solve the problems discussed above.

In one aspect of the technology, a masking tool for a turbine component that is configured to receive and cover a portion of the turbine component, the masking tool includes a first casing part; a second casing part configured to engage the first casing part to form a chamber configured to receive a portion of the turbine component; and an anchor configured to secure the masking tool to a mounting table, wherein the masking tool is configured to leave part of the turbine component exposed to atmosphere when the first and second casing parts are secured together and receive the turbine component, wherein the first and second casing parts are configured to be compressed against each other when secured together, wherein the first and second casing parts are configured to seal a space containing portions of the turbine component without an elastomeric seal, and wherein an interior surface of the first casing part and an interior surface of the second casing part are contoured to match a contour of the turbine component.

A further aspect of the technology includes the preceding aspect and wherein the first and second casing parts have openings that allow a portion of the turbine component to be exposed to a surrounding environment while the first and second casing parts are secured together and receive the turbine component.

A further aspect of the technology includes any of the preceding aspects and wherein the portion of the turbine component is a root pocket area.

A further aspect of the technology includes any of the preceding aspects and wherein the portion of the turbine component is an airfoil portion.

A further aspect of the technology includes any of the preceding aspects and wherein the portion of the turbine component is a plurality of vanes of a doublet vane assembly.

A further aspect of the technology includes any of the preceding aspects and wherein only the first casing part or the second casing part includes an opening configured to leave a portion of the turbine component exposed so that only a portion of one side of the turbine component remains exposed to atmosphere when enclosed within the masking tool.

A further aspect of the technology includes any of the preceding aspects and wherein a portion of the interior surface of the first casing part is convex and a portion of the interior surface of the second casing part is concave.

A further aspect of the technology includes any of the preceding aspects and wherein the first and second casing parts form a chamber that is open on a top side when the first and second casing parts are secured together.

A further aspect of the technology includes any of the preceding aspects and wherein the first and second casing parts are configured to form a cuboid shape with a part of the turbine component when the first and second casing parts are secured to each other and receive the turbine component.

A further aspect of the technology includes any of the preceding aspects and wherein the masking tool is formed by way of a 3D printing process.

A further aspect of the technology includes any of the preceding aspects and wherein the chamber is exposed to atmosphere.

A further aspect of the technology includes a protective coating system for applying a protective coating to a turbine component, the system including a housing that encloses a chamber, the chamber being accessible by way of the opening of a door of the housing; a mounting table in the chamber; and the masking tool of any of the preceding aspects wherein the anchor of the masking tool is configured to be secured to the mounting table.

A further aspect of the technology includes any of the preceding aspects and wherein the system is a physical vapor deposition (PVD) system utilizing a cathodic arc coating tool.

A further aspect of the technology includes any of the preceding aspects and wherein the system is a low-pressure plasma spray (LPPS) system.

A further aspect of the technology includes a method of loading a turbine component into a masking tool for a protective coating system, the method including separating or partially separating casing parts of the masking tool to open access to a holding chamber of the masking tool; inserting the turbine component into the chamber; and securing together the casing parts of the masking tool to create a tight fit between the casing parts of the masking tool and the turbine component that is substantially impermeable to the protective coating, wherein part of the turbine component remains uncovered after the casing parts of the masking tool are secured together, and wherein one or more interior surfaces of the casing parts is contoured to match a contour of the turbine component so that at least a part of the turbine component abuts against the one or more contoured interior surfaces.

A further aspect of the technology includes the preceding aspect and wherein the coating impermeable tight fit between the casing parts is created without an elastomeric seal.

A further aspect of the technology includes any of the preceding aspects and wherein the part of the turbine component that remains uncovered is a root pocket area.

A further aspect of the technology includes any of the preceding aspects and wherein the part of the turbine component that remains uncovered is an airfoil portion.

A further aspect of the technology includes any of the preceding aspects and wherein the turbine component is a doublet vane assembly and the parts of the turbine component that remains uncovered are the vanes.

A further aspect of the technology includes any of the preceding aspects and further includes attaching an anchor to a first casing part of the casing parts, wherein the anchor secures the masking tool to a chamber floor in which coating material is deposited on the masking tool and the exposed portion of the turbine vane.

A further aspect of the technology includes any of the preceding aspects and wherein the first and second casing parts are connected by a hinge.

### BRIEF DESCRIPTION OF THE DRAWINGS

Fig. 1A illustrates a first type of protective coating system.
Fig. 1B illustrates a second type of protective coating system.
Figs. 2A and 2B are perspective views of an exemplary turbine component.
Fig. 3A is a perspective views of a masking tool without the turbine component.
Figs. 3B and 3C are perspective views of the masking tool of Fig. 3A with the turbine component held within.
Fig. 4A is a perspective view of part of a masking tool.
Fig. 4B is a perspective view of the part of the masking tool of Fig. 4A with a turbine component being held therein.
Figs. 4C-4G are perspective views of the masking tool of Fig. 4A with the turbine component being held therein.
Figs. 5A-5F are perspective views of another masking tool.
Figs. 6A-6C are perspective views of another masking tool.
Figs. 6D-6I are illustrations of a method of loading a turbine component into the masking tool.

### DETAILED DESCRIPTION OF EXAMPLE NON-LIMITING EMBODIMENTS

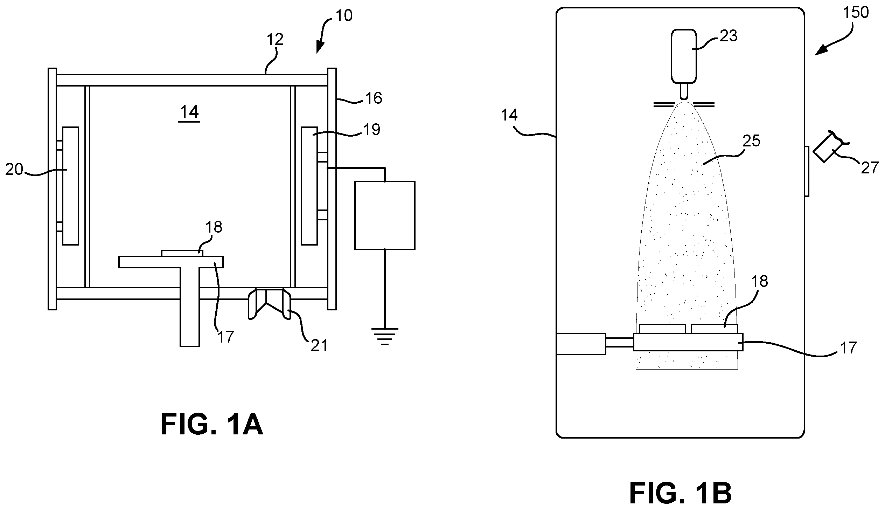

Fig. 1A illustrates an exemplary turbine component coating system 10. The coating system 10 may be in the form of a physical vapor deposition (PVD) system utilizing a cathodic arc coating tool and may include a housing 12 that encloses a chamber 14. The chamber 14 may be accessible by way of the opening of a door 16. The coating system 10 may further include a mounting table 17 for supporting a turbine component, such as a turbine blade or vane, enclosed within a masking tool 18. The mounting table 17 with the masking tool 18 may be positioned between an anode 19 and a cathode 20. The chamber 14 may include an outlet 21 in communication with a vacuum pump (not shown).

Fig. 1B illustrates another exemplary turbine component coating system 150 in the form of a low pressure plasma spray (LPPS) system. The coating system 150 may include a chamber 14 in which a mounting table 17 is positioned to support the masking tool 18 with the turbine component, such as a turbine blade enclosed therein. A plasma torch 23 may direct a plasma stream 25 to the masking tool 18, and an infrared pyrometer 27 may irradiate the plasma stream 25. It should be understood that although two types of coating systems are illustrated, any type of system capable of applying a protective coating to a turbine component may be used.

It is also contemplated that the turbine coating system may be an electron-beam physical vapor deposition (EB-PVD system).

During operation of a conventional turbine, different regions of each turbine component are subjected to different conditions. That is, different regions of each turbine component are subjected to different temperatures and stresses. Accordingly, for each turbine component, different types of protective coatings are applied to different regions of the turbine component. In order to prevent a particular coating type from being deposited on an undesired portion of the turbine component, the turbine component may be encased within the masking tool to cover the portions of the turbine component that are not to be coated.

In order to ensure that the coating deposit does not seep into undesired regions of the turbine component, the masking tool may be contoured to conform to the shape of the turbine component and may be shaped to leave certain portions of the turbine component exposed.

The embodiments described herein refer to turbine components, including but not limited to blades, vanes, or other turbine components. For ease of description, the turbine component will be referred to as an exemplary "turbine blade" unless otherwise noted. However, this description is not intended to limit the embodiments in any manner.

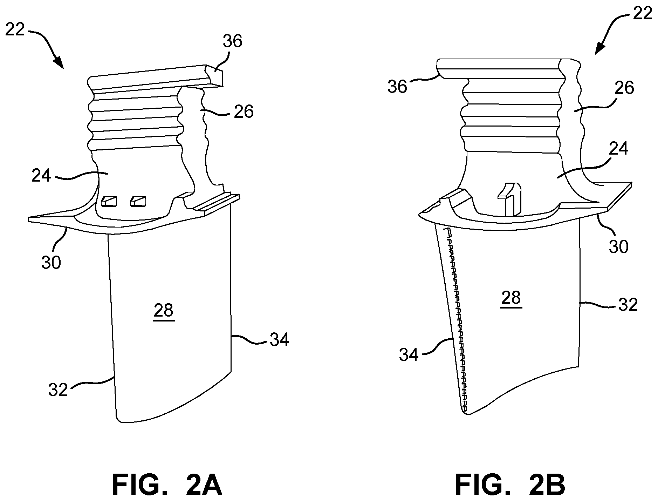

Figs. 2A and 2B show an exemplary turbine blade 22 with a root pocket area 24, a root region 26, an airfoil region 28, and a platform 30. The root pocket area 24 and the platform 30 may be positioned between the root region 26 and the airfoil region 28 with the root pocket area 24 being adjacent to the root region 26 and the platform 30 being located between the airfoil region 28 and the root pocket area 24. In Fig. 2A, the convex surface of the airfoil region 28 is visible and extends from the wider leading edge 32 to the narrower trailing edge 34. In Fig. 2B, the concave surface of the airfoil region 28 is visible and extends from the narrower trailing edge 34 to the wider leading edge 32. In addition, the root region 26 includes a plurality of ridges and an end portion 36 that extends laterally beyond the rest of the root region 26. Also, a surface of the platform 30 that faces the airfoil region 28 is convex.

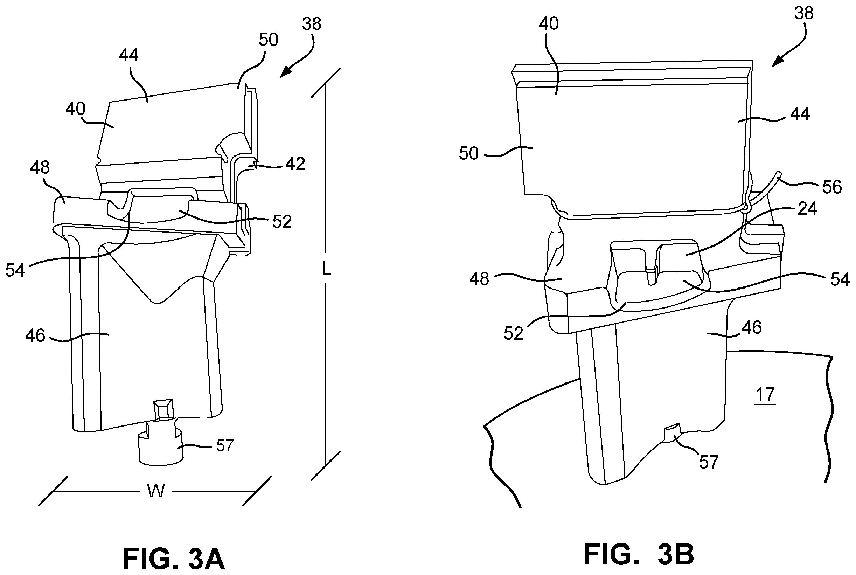

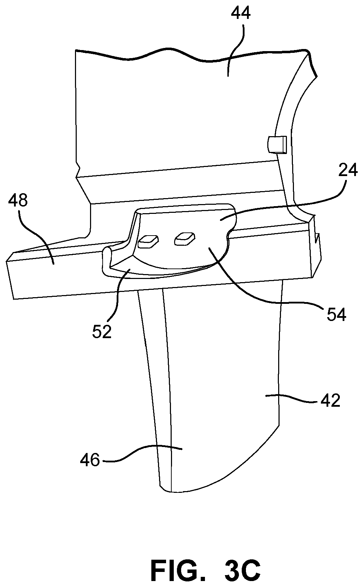

Figs. 3A-3C show an exemplary masking tool 38 for masking the turbine blade 22 of Figs. 2A and 2B. The masking tool 38 is intended to be used in a cathodic arc deposition system. However, it is contemplated that the masking tool 38 may be used in other coating systems. The mask tool 38 is configured to mask all portions of the turbine blade 22 except for the root pocket area 24 so that only the root pocket area 24 receives the protective coating during the coating process.

The masking tool 38 may comprise a first casing part 40 and a second casing part 42 configured to be secured to the first casing part 40 to form an enclosure around the turbine blade 22 that leaves a portion of the turbine blade 22 exposed to atmosphere. In the configuration illustrated in Figs. 3A-3C, the open portion of the masking tool 38 is located at the root pocket area 24 of the turbine blade 22 so that the root pocket area 24 is exposed to atmosphere. However, the masking tool 38 may be designed to leave any part of the turbine blade 22 exposed to atmosphere depending on what part of the turbine blade 22 is intended to be coated.

The first casing part 40 may be configured to cover the side of the turbine blade 22 with the concave airfoil surface, while the second casing part 42 may be configured to cover the side of the turbine blade 22 with the convex airfoil surface without engaging or contacting the root pocket area 24. Each of the first casing part 40 and the second casing part 42 may comprise a root region cover portion 44, an airfoil cover portion 46, and a platform cover portion 48 between the root region cover portion 44 and the airfoil cover portion 46.

Each of the covering portions of the first and second casing parts 40, 42 may be contoured to tightly fit against the turbine blade 22. For example, the root region cover portion 44 may be configured to cover the root region 26. In addition, an interior-facing surface of the root region cover portion 44 may include ridges similar to the ridges on the root region 26. For a tight fit, the ridges on the root region cover portion 44 may be positioned to engage the valleys on the root region 26. The root region cover portion 44 may also include valleys between the ridges, and the valleys of the root region cover portion 44 may be positioned to engage the ridges of the root region 26. It is contemplated that the root region cover portion 44 may also include a laterally projecting portion 50 that accommodates the end portion 36.

In addition, the airfoil cover portion 46 of the first and second casing parts 40, 42 may be configured to cover the airfoil region 28. Thus, the airfoil cover portion 46 may be contoured to complement the shape of the airfoil region 28. For example, the inwardly facing surface of the airfoil cover portion 46 of the first casing part 40 may be convex to abut against (or contact) the concave surface of the airfoil region 28. Conversely, the inwardly facing surface of the airfoil cover portion 46 of the second casing part 42 may be concave to abut against (or contact) the concave surface of the airfoil region 28.

The platform cover portion 48 may be configured to cover the platform 30. Accordingly, the platform cover portion 48 may extend laterally beyond the root region cover portion 44 and the airfoil cover portion 46.

Both of the first and second casing parts 40, 42 may include an opening 52 that is sized and shaped so that a portion of or the entirety of the root pocket area 24 remains uncovered by the masking tool 38. The opening 52 may be bound entirely by the platform cover portion 48 or by a combination of the platform cover portion 48 and the root region cover portion 44. In addition, first and second casing parts 40, 42 may be configured so that the openings 52 in the first and second casing parts 40, 42 form a chamber 54 that receives the root pocket area 24 and is sealed off from the rest of the interior of the masking tool 38.

It is contemplated that only the first casing part 40 or the second casing part 42 includes the opening 52. In this configuration, only one side of the root pocket area 24 would be exposed to atmosphere. The other side would be masked like the rest of the turbine blade 22.

The sealing off of the chamber 54 from the rest of the interior of the masking tool 38 may be made by compressing the first and second casing parts 40, 42 together. In addition, the manufacturing tolerances of the first and second casing parts 40, 42 may be small enough so that the seams between the two parts are small enough to effectively function as a seal to prevent any seepage or leakage of the coating material onto any part of the turbine blade 22 other than the root pocket area 24. In other words, the tolerances of the first and second casing parts 40, 42 may be small enough to form a seal between the first and second casing parts 40, 42 without using an elastomeric seal. This may increase the longevity of the masking tool 38 because the lack of an elastomeric sealing part leaves one less component that could deteriorate under the operating conditions of the masking tool 38. Nonetheless, it is contemplated that either or both of the first and second casing parts 40, 42 may include one or more elastomeric seals to seal off the chamber 54 from the rest of the interior of the masking tool 38 and to seal off the interior of the masking tool 38 from the outside at the perimeter of the masking tool 38.

It is contemplated that the entire interior surface of each of the first and second casing parts 40, 42 may be contoured so that the entire interior surface of each of the first and second casing parts 40, 42 abuts against (or contacts) the turbine blade 22 when the first and second casing parts 40, 42 are secured together and enclose the turbine blade 22. Such a configuration would prevent seepage of particles onto the surfaces covered by the first and second casing parts 40, 42.

Alternatively, only a portion of the interior surfaces of the first and second casing parts 40, 42 may be contoured to abut against (or contact) the turbine blade 22. For example, only the perimeters of the first and second casing parts 40, 42 and the perimeters of the openings 52 would abut against (or contact) the turbine blade 22. In yet another example, the interior surfaces of the first and second casing parts 40, 42 would intermittently abut against (or contact) the turbine blade 22 (i.e., in addition to the perimeters of the first and second casing parts 40, 42 other portions of the interior surfaces of the first and second casing parts 40, 42 would abut against (or contact) the turbine blade 22. Having only some of the interior surface of the first and second casing parts 40, 42 engage the turbine blade 22 may allow for manufacturing tolerances and prevent seepage due to minor inconsistencies in the shapes of different turbine blades 22 so that one masking tool 38 can be used with multiple turbine blades 22 of a particular shape and size.

As shown in Fig. 3B, the first and second casing parts 40, 42 may be secured together by way of a fastening device 56. The fastening device 56 may be a simple wire looped around the masking tool 38. The loop may be tightened to provide a compressive force against the first and second casing parts 40, 42. Alternatively, the first and second casing parts 40, 42 may be secured together by way of a snap fit connection, one or more clips, one or more bolts, or any other fastening device, now known or hereinafter developed, capable of compressing the first and second casing parts 40, 42 against each other. It is further contemplated that the first and second casing parts 40, 42 are fully separable. Alternatively, the first and second casing parts 40, 42 may be connected to each other by way of a hinge and may be pivoted between an open position and a closed position.

The masking tool 38 may have a length L (the combined lengths of the root region cover portion 44, the airfoil cover portion 46, and the platform cover portion 48) within a range of about 5 to about 15 cm (e.g., about 11 cm). The maximum W width of the root region cover portion 44 may be within a range of about 3 to about 7 cm (e.g., about 4.5 cm). In addition, a minimum width w of the airfoil cover portion 46 may be about 3 to about 7 cm (e.g., about 5 cm).

As discussed above, the masking tool 38 may be designed so that other parts of the turbine blade 22 besides the root pocket area 24 remain exposed to atmosphere. For example, the opening 52 may be located adjacent to the airfoil region 28, the platform 30, and/or the root region 26. The opening 52 may be sized so that the entirety of the airfoil region 28, the platform 30, or the root region 26 is exposed; only a portion of the airfoil region 28, the platform 30, the root region 26; or a combination of the airfoil region 28, the platform 30, and the root region 26 are exposed.

In some cases in which the airfoil region 28 is exposed to atmosphere, the length L of the masking tool 38 may be shortened and the masking tool 38 may terminate at the platform 30 (while enclosing the platform 30). The length L of the masking tool 38 may also be shortened and the masking tool 38 may terminate at the root pocket area 24 or at the platform 30 (enclosing the platform 30 or enclosing the platform 30 and the root pocket area 24).

In addition, as discussed above, the masking tool 38 may leave only one side of the turbine blade exposed. In such a configuration, the first or second casing part 40, 42 may extend the length of the turbine blade and the other of the first or second casing part 40, 42 may terminate prior to the airfoil region 28 or the root region 26. In this configuration, the lengths L of the first and second casing parts 40, 42 may be different.

The masking tool 38 may also include an anchor 57 configured to anchor the masking tool 38 to the mounting table 17. The anchor 57 may be in the form of any device capable of removably anchoring the masking tool 38 to the mounting table 17. For example, the anchor 57 may comprise a bayonet system, a bolt, a threaded fastener, etc.

By securing the masking tool 38 to the mounting table 17, the turbine blade 22 may be stabilized during the coating process so that a substantially consistent layer of coating may be applied to all intended surfaces of the turbine blade 22. It is contemplated that the anchor 57 may lock or secure the masking tool 38 to the mounting table 17 in a manner that allows the masking tool 38 to rotate relative to the coating applicator or allows the masking tool 38 to be held in place and in a particular orientation while the coating applicator moves around the masking tool 38.

It is further contemplated that the mounting table 17 may include a receptacle (not shown) specific to the anchor 57 so that all masking tools 38 may be positioned in a particular location on the mounting table 17. In other words, a particular location on the mounting table 17 may be chosen for securing masking tools 38 that are designed to coat only the root pocket area 24. The specific location on the mounting table 17 for mounting the masking tool 38 may allow for the coating of the root pocket area 24 to be substantially consistent for all turbine blades 22.

It is also contemplated that there may be multiple receptacles on the mounting table 17 configured to receive the anchor 57. In other words, the anchor 57 and the mounting table 17 may be configured so that the masking tool 38 is only securable to the mounting table 17 at one or more discreet locations.

In addition, it is contemplated that the first and second casing parts 40, 42 may be formed by way of a 3D printing process. Alternatively, the first and second casing parts 40, 42 may be formed by a molding process. It is further contemplated that the first and second casing parts 40, 42 may be formed by welding sheet metal together. In addition, each of the first and second casing parts 40, 42 may be a continuous unitary body. However, it is contemplated that one or more of the root region cover portion 44, the airfoil cover portion 46, and the platform cover portion 48 may be separately formed and assembled to the other portions of the first and/or second casing parts 40, 42. In addition, the masking tool 38 may be formed from any material that remains stable at about 2000°F (1093°C). For example, the masking tool 38 may be formed from a material that is about 40 to about 70% nickel (e.g., a nickel-chromium alloy). It is contemplated that the material from which the masking tool 38 is formed may also be a cobalt-based alloy.

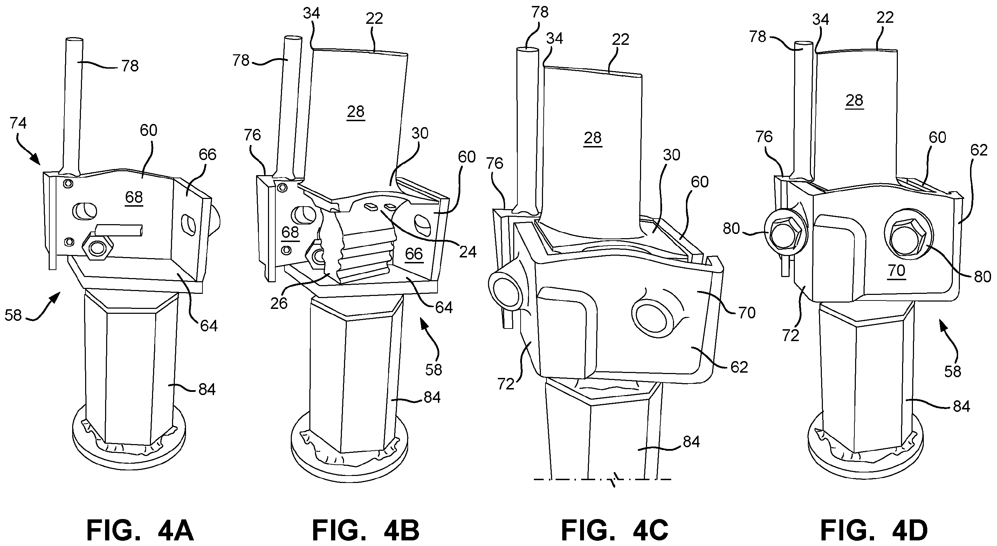

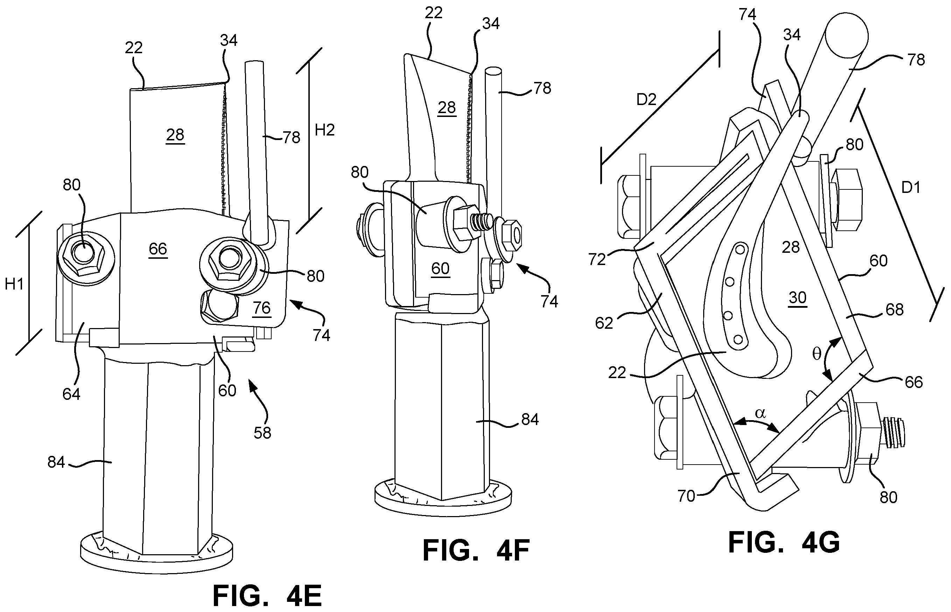

Figs. 4A-4G illustrate another exemplary masking tool 58 for masking the turbine blade 22 of Figs. 2A and 2B. The masking tool 58 is intended to be used in an LPPS system. However, it is contemplated that the masking tool 58 may be used in other coating systems. In the configuration illustrated in Figs. 4A-4G, the masking tool 58 is shown to mask all portions of the turbine blade 22 except for the airfoil region 28 and the portion of the platform 30 facing the airfoil region 28 so that only the airfoil region 28 and the portion of the platform 30 facing the airfoil region 28 receive the protective coating during the coating process. However, the masking tool 58 may be designed to leave any part of the turbine blade 22 exposed to atmosphere depending on what part of the turbine blade 22 is intended to be coated.

The masking tool 58 illustrated in Figs. 4A-4G may be similar to existing masking tools that are formed from welded sheet metal. However, the separate parts of the masking tool 58 may be tailored to the particular turbine component being masked so that the portions of the turbine component intended to remain uncoated are sealed off from the portions intended to be coated to prevent seeping and/or leakage into the portions intended to remain uncoated. This may be accomplished by a tight, conforming fit and/or a seal (e.g., elastomeric or foam seal) attached to the separate parts (e.g., at the edges that contact the turbine component or other parts of the masking tool 58. In addition, the masking tool 58 may be formed from a 3D printing process. Alternatively, the masking tool 58 may be formed by way of a molding process. The masking tool 58 may be formed from any material that remains stable at about 2000°F (1093°C). For example, the masking tool 58 may be formed from a material that is about 40 to about 70% nickel (e.g., a nickel-chromium alloy). It is contemplated that the material from which the masking tool 58 is formed may be a cobalt-based alloy.

The masking tool 58 may comprise a first casing part 60 and a second casing part 62 configured to be secured to the first casing part 60 without contacting or engaging the airfoil region 28 or the surface of the platform 30 facing the airfoil region 28. The first casing part 60 may comprise a horizontal bottom wall 64 and two adjacent vertical walls 66, 68. The second casing part 62 may comprise an additional two vertical walls 70, 72 adjacent to each other. When the first and second casing parts 60, 62 are secured together, they may form a cuboid shape. It should be understood that although a cuboid shape is illustrated, the chamber formed by the first and second casing parts 60, 62 may be any three-dimensional shape, the top face of which matches the shape of the perimeter of the platform 30. In addition, an angle θ between the vertical walls 66, 68 (which is the same as the angle between the vertical walls 70, 72) may be within a range of 90-150 degrees (e.g., about 125°). Also, an angle α between the vertical walls 66, 70 (which is the same as the angle between the vertical walls 68,72) may be between 30 and 90 degrees (e.g., 55°).

Also, similar to the masking tool 38, some or all of the interior surfaces of the masking tool 58 may be contoured to match the contours of the turbine blade 22. In such a configuration, the walls 66, 68, 70, and 72 may form a shape that substantially mirrors the shape of the turbine blade 22 (e.g., the root region 26. It is also contemplated that the interior surfaces of the walls 66, 68, 70, or 72 may include ridges and valleys that match the ridges and valleys of the root region 26 so that valleys of the masking tool 58 receive the ridges of the root region 26 and valleys of the root region 26 receive ridges of the masking tool 58. In addition, it is contemplated that only the perimeters of the first and second casing parts 60, 62 abut against (or contact) the turbine blade 22.

Also, as can be seen in Fig. 4G, one end of each of the walls 68 and 70 may be laterally bent at an angle (e.g., about 90°) so that when the first and second casing parts 60, 62 are secured together, the bent end of the wall 68 overlaps an outer surface of the wall 72 and the bent end of the wall 70 overlaps an outer surface of the wall 66. The overlapping of the walls may ensure a tight fit as well as providing an interface that helps separate the first and second casing parts 60, 62 after use.

The chamber formed by the first and second casing parts 60, 62 may be open on the top so that the platform 30 may enclose the chamber when the turbine blade 22 is inserted into the masking tool 58. The chamber may receive the root pocket area 24 and the root region 26 so that those portions of the turbine blade 22 are isolated and sealed off from the outside by the walls of the first and second casing parts 60, 62, and the platform 30.

The masking tool 58 may include an external masking part 74. The external masking part 74 may include a base 76 and a projecting member 78. The base 76 may be configured to attach the external masking part 74 to an outside surface of the first casing part 60. It is contemplated that the base 76 may be attached to the vertical wall 66 of the first casing part 60. The projecting member may extend vertically from the base 76 at a location adjacent to the trailing edge 34 of the airfoil region 28 of the turbine blade 22. In that location, the projecting member 78 may prevent coating material from building up on the trailing edge 34. It should be understood that the external masking part 74 is positioned adjacent to the trailing edge 34 regardless of the position of the trailing edge relative to the first and second casing parts 60, 62. In other words, the external masking part 74 may be positioned at whichever location facilitates the projecting member 78 being adjacent to the trailing edge 34.

The sealing off of the root region 26 and the root pocket area 24 from the exterior of the masking tool 58 may be made by compressing the first and second casing parts 60, 62 together. In addition, the manufacturing tolerances of the first and second casing parts 60, 62 may be small enough so that the seams between the first and second casing parts 60, 62 and the platform 30 are small enough to effectively function as a seal to prevent seepage or leakage of the coating material onto any part of the turbine blade 22 other than the airfoil region 28 and the surface of the platform 30 facing the airfoil region 28. In other words, the tolerances of the first and second casing parts 60, 62 may be small enough to form a seal between the first and second casing parts 60, 62 and the platform 30 without using an elastomeric seal. This may increase the longevity of the masking tool 58 because the lack of an elastomeric sealing part leaves one less part that could deteriorate under the operating conditions of the masking tool 58. Nonetheless, it is contemplated that either or both of the first and second casing parts 60, 62 may include one or more elastomeric seals to seal off the root region 26 and the root pocket area 24 from outside the masking tool 58.

The first and second casing parts 60, 62 may be secured together by way of a fastening device 80. In addition, the external masking part 74 may be secured to the first or second casing part 60, 62 by way of a fastening device 82. The fastening devices 80, 82 may be one or more bolts that may be tightened to provide a compressive force against the first and second casing parts 60, 62. Alternatively, the first and second casing parts 60, 62 and the external masking part 74 may be secured together by way of a snap fit connection, one or more clips, a wire looped around the masking tool 58 or any other fastening device, now known or hereinafter developed, capable of compressing the first and second casing parts 60, 62 against each other. It is further contemplated that the first and second casing parts 60, 62 and the external masking part 74 are fully separable. Alternatively, the first and second casing parts 60, 62 may be connected to each other by way of a hinge and may be pivoted between an open position and a closed position.

The masking tool 58 may also include an anchor 84 configured to anchor the masking tool 58 to the mounting table 17. The anchor 84 may be in the form of any device capable of removably anchoring the masking tool 58 to the mounting table 17. For example, the anchor 84 may comprise a bayonet system, a bolt, a threaded fastener, etc.

By securing the masking tool 58 to the mounting table 17, the turbine blade 22 may be stabilized during the coating process so that a substantially consistent layer of coating may be applied to all intended surfaces of the turbine blade 22. It is contemplated that the anchor 84 may lock or secure the masking tool 58 to the mounting table 17 in a manner that allows the masking tool 58 to rotate relative to the coating applicator or allows the masking tool 58 to be held in place and in a particular orientation while the coating applicator moves around the masking tool 58.

It is further contemplated that the mounting table 17 may include a receptacle (not shown) specific to the anchor 84 so that all masking tools 58 may be positioned in a particular location on the mounting table 17. In other words, a particular location on the mounting table 17 may be chosen for securing masking tools 58 that are designed to coat only the airfoil region 28 and one of the surfaces of the platform 30. The specific location on the mounting table 17 for mounting the masking tool 58 may allow for the coating of the root pocket area 24 to be substantially consistent for all turbine blades 22.

It is also contemplated that there may be multiple receptacles on the mounting table 17 configured to receive the anchor 84. In other words, the anchor 84 and the mounting table 17 may be configured so that the masking tool 58 is only securable to the mounting table 17 at one or more discreet locations.

In addition, the anchors 57 and 84 may be configured so that they are not able to be secured to the mounting table 17 at the same location. In other words, the locations at which the masking tool is securable to the mounting table may depend on the type of masking tool being used. Alternatively, the mounting table 17 may include universal receptacles that may receive the anchors for any type of masking tool.

The vertical walls 66 and 70 may be shaped and sized so that a distance D1 between the interior surfaces of the walls 66 and 72 is between about 5 and about 10 cm (e.g., about 8 cm). In addition, the vertical walls 68 and 72 may be shaped and sized so that a distance D2 between the walls 68 and 70 is between about 5 and about 10 cm (e.g. about 4.5 cm) The masking tool 58 has a height H1 which is the maximum height of the vertical walls 66, 68, 70, 72 and may be within a range of about 3 to about 7 cm (e.g., about 4.5 cm). The masking tool 58 has a second height H2 which is a distance by which the projecting member 78 extends beyond the adjacent vertical wall and may be about 3 to about 10 cm (e.g., about 7 cm).

Although the first and second casing parts 60, 62 and the external masking part 74 are illustrated as separate parts, each of the first and second casing parts 60, 62 and the external masking part 74 may be a continuous unitary body.

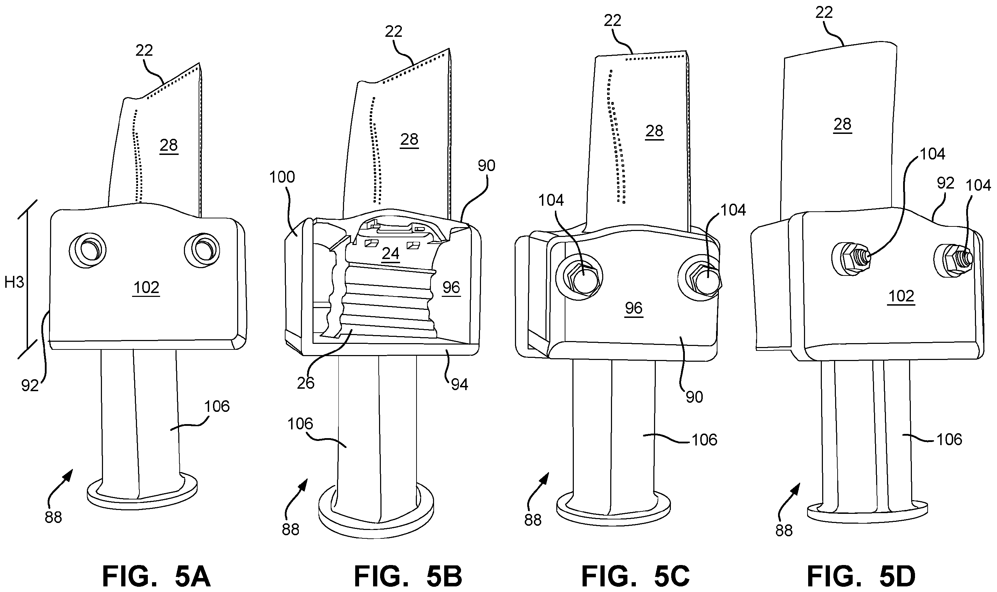

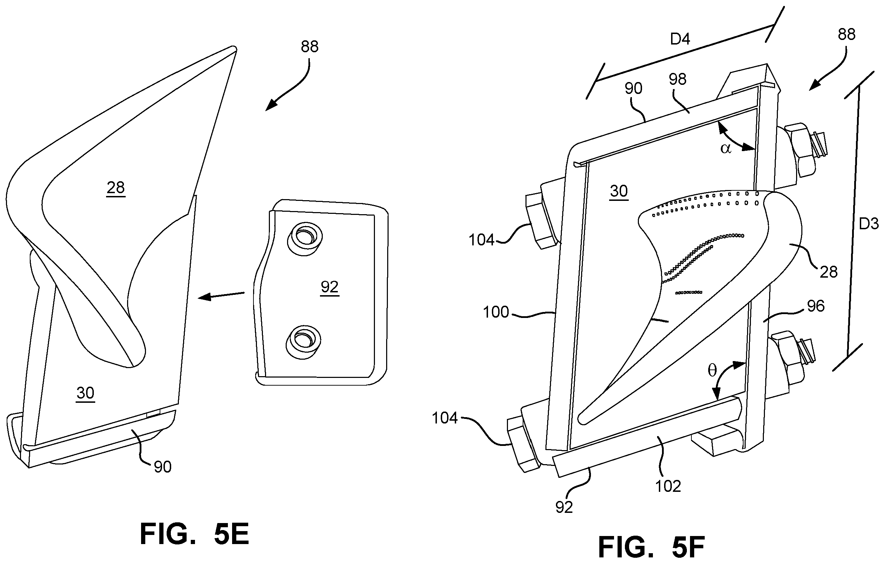

Figs. 5A-5F illustrate another exemplary masking tool 88 for masking the turbine blade 22 of Figs. 2A and 2B. The masking tool 88 is similar to the masking tool 58 except that the masking tool 88 does not include an external masking part with a projecting member. Accordingly, the masking tool 88 is intended to be used in an LPPS system but can be used in other coating systems. In the configuration illustrated in Figs. 5A-5F, the masking tool 88 is configured to mask all portions of the turbine blade 22 except for the airfoil region 28 and the portion of the platform 30 facing the airfoil region 28 so that only the airfoil region 28 and the portion of the platform 30 facing the airfoil region 28 receive the protective coating during the coating process. However, the masking tool 58 may be designed to leave any part of the turbine blade 22 exposed to atmosphere depending on what part of the turbine blade 22 is intended to be coated.

The masking tool 88 illustrated in Figs. 5A-5F is similar to existing masking tools that are formed from welded sheet metal. However, the masking tool 88 is formed from a 3D printing process. Alternatively, the masking tool 88 may be formed by way of a molding process. The masking tool 88 may be formed from any material that remains stable at about 2000°F (1093°C). For example, the masking tool 88 may be formed from a material that is about 40 to about 70% nickel (e.g., a nickel-chromium alloy). It is contemplated that the material from which the masking tool 88 is formed may be a cobalt-based alloy.

The masking tool 88 may comprise a first casing part 90 and a second casing part 92 configured to be secured to the first casing part 90. The first casing part 90 may comprise a horizontal bottom wall 94 and three adjacent vertical walls 96, 98, 100. The second casing part 92 may comprise an additional vertical wall 102. When the first and second casing parts 90, 92 are secured together, they may form a cuboid shape. It should be understood that although a cuboid shape is illustrated, the chamber formed by the first and second casing parts 90, 92 may be any three-dimensional shape, the top face or which matches the shape of the perimeter of the platform 30. In addition, an angle θ between the vertical walls 96, 102 (which is the same as the angle between the vertical walls 98, 100) may be within a range of about 90 to about 150 degrees (e.g., about 125°). In addition, an angle α between the vertical walls 96, 98 (which is the same as the angle between the vertical walls 100, 102) may be between about 30 and about 90 degrees (e.g., about 55°).

Also, similar to the masking tool 38, some or all of the interior surfaces of the masking tool 88 may be contoured to match the contours of the turbine blade 22. In such a configuration, the walls 96, 98, 100, and 102 may form a shape that substantially mirrors the shape of the turbine blade 22 (e.g., the root region 26. It is also contemplated that the interior surfaces of the walls 96, 98, 100, and 102 may include ridges and valleys that match the ridges and valleys of the root region 26 so that valleys of the masking tool 88 receive the ridges of the root region 26 and valleys of the root region 26 receive ridges of the masking tool 88. In addition, it is contemplated that only the perimeters of the first and second casing parts 90, 92 abut against (or contact) the turbine blade 22.

Also, as can be seen in Fig. 5F, both ends of the wall 96 may be laterally bent at an angle (e.g., about 90°) so that when the first and second casing parts 90, 92 are secured together, the bent ends of the wall 96 overlaps an outer surface of the wall 98 and an outer surface of the wall 102. The overlapping of the walls may ensure a tight fit as well as providing an interface that helps separate the first and second casing parts 90, 92 after use.

The chamber formed by the first and second casing parts 90, 92 may be open on the top so that the platform 30 may enclose the chamber when the turbine blade 22 is inserted into the masking tool 88. The chamber may receive the root pocket area 24 and the root region 26 so that those portions of the turbine blade 22 are isolated and sealed off from the outside by the walls of the first and second casing parts 90, 92, and the platform 30.

The sealing off of the root region 26 and the root pocket area 24 from the exterior of the masking tool 88 may be made by compressing the first and second casing parts 90, 92 together. In addition, the manufacturing tolerances of the first and second casing parts 90, 92 may be small enough so that the seams between the two parts and the platform 30 are small enough to effectively function as a seal to prevent seepage or leakage of the coating material onto any part of the turbine blade 22 other than the airfoil region 28 and the surface of the platform 30 facing the airfoil region 28. In other words, the tolerances of the first and second casing parts 90, 92 may be small enough to form a seal between the first and second casing parts 90, 92 and the platform 30 without using an elastomeric seal. This may increase the longevity of the masking tool 88 because the lack of an elastomeric sealing part leaves one less part that could deteriorate under the operating conditions of the masking tool 88. Nonetheless, it is contemplated that either or both of the first and second casing parts 90, 92 may include one or more elastomeric seals to seal off the root region 26 and the root pocket area 24 from outside the masking tool 88.

The first and second casing parts 90, 92 may be secured together by way of a fastening device 104. The fastening device 104 may be one or more bolts that may be tightened to provide a compressive force against the first and second casing parts 90, 92. Alternatively, the first and second casing parts 90, 92 may be secured together by way of a snap fit connection, one or more clips, a wire looped around the masking tool 88, or any other fastening device, now known or hereinafter developed, capable of compressing the first and second casing parts 90, 92 against each other. It is further contemplated that the first and second casing parts 90, 92 are fully separable. Alternatively, the first and second casing parts 90, 92 may be connected to each other by way of a hinge and may be pivoted between an open position and a closed position.

The masking tool 88 may also include an anchor 106 configured to anchor the masking tool 88 to the mounting table 17. The anchor 106 may be in the form of any device capable of removably anchoring the masking tool 88 to the mounting table 17. For example, the anchor 106 may comprise a bayonet system, a bolt, a threaded fastener, etc.

By securing the masking tool 88 to the mounting table 17, the turbine blade 22 may be stabilized during the coating process so that a substantially consistent layer of coating may be applied to all intended surfaces of the turbine blade 22. It is contemplated that the anchor 106 may lock or secure the masking tool 88 to the mounting table 17 in a manner that allows the masking tool 88 to rotate relative to the coating applicator or allows the masking tool 88 to be held in place and in a particular orientation while the coating applicator moves around the masking tool 88.

It is further contemplated that the mounting table 17 may include a receptacle (not shown) specific to the anchor 106 so that all masking tools 88 may be positioned in a particular location on the mounting table 17. In other words, a particular location on the mounting table 17 may be chosen for securing masking tools 88 that are designed to coat only the airfoil region 28 and one of the surfaces of the platform 30. The specific location on the mounting table 17 for mounting the masking tool 88 may allow for the coating of the airfoil region 28 and one of the surfaces of the platform 30 to be substantially consistent for all turbine blades 22.

It is also contemplated that there may be multiple receptacles on the mounting table 17 configured to receive the anchor 106. In other words, the anchor 106 and the mounting table 17 may be configured so that the masking tool 88 is only securable to the mounting table 17 at one or more discreet locations.

In addition, the anchors 57 and 84 may be configured so that they are not able to be secured to the mounting table 17 at the same location as the anchor 106. In other words, the locations at which the masking tool is securable to the mounting table may depend on the type of masking tool being used. Alternatively, the mounting table 17 may include universal receptacles that may receive the anchors for any type of masking tool.

The vertical walls 96 and 100 may be sized and shaped so that a distance D3 between the interior surfaces of the walls 98 and 102 is between about 10 and about 20 cm (e.g., about 15 cm). In addition, the vertical walls 98 and 102 may be sized and shaped so that a distance D3 between the interior surfaces of the walls 96 and 100 is between about 5 and about 15 cm (e.g. about 9 cm) The maximum height H3 of the vertical walls 96, 98, 100, 102 may be within a range of about 5 to about 15 cm (e.g., about 8 cm).

Although the first and second casing parts 90, 92 are illustrated as separate parts, each of the first and second casing parts 90, 92 may be a continuous unitary body.

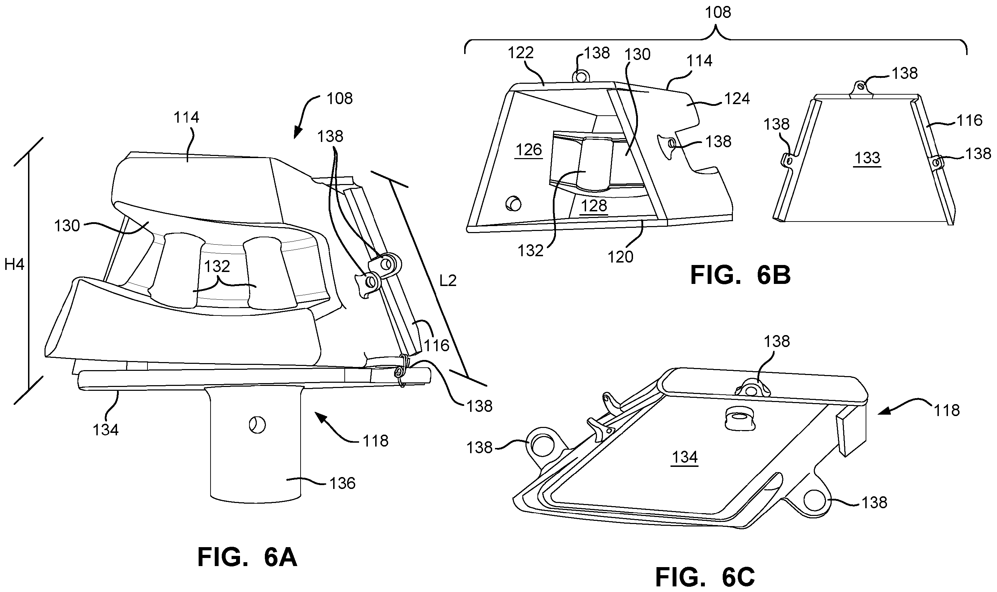

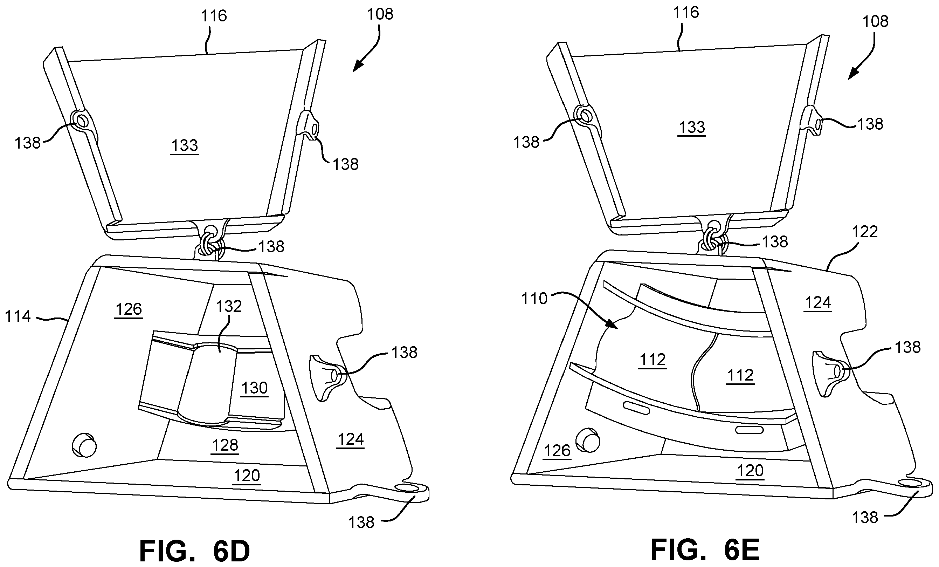

Figs. 6A-6I illustrate another exemplary masking tool 108 for masking a turbine doublet vane assembly 110 (see Fig. 6D). The masking tool 108 is intended to be used in an EB-PVD system but can be used in other coating systems. In the configuration illustrated in Figs. 6A-6I, the masking tool 108 is configured to receive the entirety of the doublet vane assembly 110 and mask all portions of the doublet vane assembly 110 except for the vanes 112 so that only the vanes 112 receive the protective coating during the coating process. However, the masking tool 108 may be designed to leave any part of the turbine doublet vane assembly 110 exposed to atmosphere depending on what part of the turbine doublet vane assembly 110 is intended to be coated.

The masking tool 108 illustrated in Figs. 6A-6I is similar to existing masking tools that are formed from welded sheet metal. However, the masking tool 108 is formed from a 3D printing process. Alternatively, the masking tool 108 may be formed by way of a molding process. The masking tool 108 may be formed from any material that remains stable at about 2000°F (1093°C). For example, the masking tool 108 may be formed from a material that is about 40 to about 70% nickel (e.g., a nickel-chromium alloy). It is also contemplated that the material from which the masking tool 108 is formed may be a cobalt-based alloy.

The masking tool 108 may comprise a first casing part 114 and a second casing part 116 configured to be secured to the first casing part 114, and a base 118 configured to be secured to a bottom side of the first casing part 114.

The first casing part 114 may be in the form of a substantially trapezoidal prism shape and may comprise a horizontal bottom wall 120, a horizontal top wall 122, and two side walls 124, 126, extending upward toward each other from the bottom wall 120 to the top wall 122. A third side wall 128 may extend from the first side wall 124 to the second side wall and may extend upward from the bottom wall 120 toward the top wall 122. The third side wall 128 may also include an inwardly projecting support 130 that is configured to support the doublet vane assembly 110 inside the masking tool 108. The support 130 may include one or more openings 132 that are sized and shaped to allow at least a portion of the vanes 112 to extend through the openings 132 so that the vanes 112 are exposed to the outside of the masking tool 108. The support 130 may be configured so that when the doublet vane assembly 110 is mounted on the support 130, the vanes 112 may be pressed against the third side wall 128 to form a barrier with the third side wall 128 that is substantially impervious to the coating material so that only the exposed portions of the vanes 112 receive the protective coating during the operation of the coating system 10. It is contemplated that the rims of the openings 132 may include one or more elastomeric seals to seal off a portion of the doublet vane assembly 110 from outside the masking tool 108. It should be understood that each vane 112 may be associated with a corresponding opening 132 and that the number of openings 132 is equal to the number of vanes 112.

The first casing part 114 may be open on a side opposite the third side wall 128 so that the first casing part 114 has a trapezoidal opening. The second casing part 116 may comprise a trapezoidal wall 133 that is shaped and sized to cover the opening in the first casing part 114 that is opposite the third side wall 128 and enclose the chamber formed by the first casing part 114.

Also, some or all of the interior surfaces of the masking tool 108 may be contoured to match the contours of the turbine doublet vane assembly 110. In such a configuration, the walls 120, 122, 124, 126, 128 may form a shape that substantially mirrors the shape of the t turbine doublet vane assembly 110.

The base 118 may be configured to secure the masking tool 108 to the mounting table 17 and may include a substantially planar base 134 and an anchor 136. The base 134 may be configured to attach to the bottom wall 120 of the first casing part 114. The anchor 136 may extend downward from the base 134 and may be attached to the mounting table 17.

By securing the masking tool 108 to the mounting table 17, the doublet vane assembly 110 may be stabilized during the coating process so that a substantially consistent layer of coating may be applied to all intended surfaces of the doublet vane assembly 110. It is contemplated that the anchor 136 may lock or secure the masking tool 108 to the mounting table 17 in a manner that allows the masking tool 108 to rotate relative to the coating applicator or allows the masking tool 108 to be held in place and in a particular orientation while the coating applicator moves around the masking tool 108.

It is further contemplated that the mounting table 17 may include a receptacle (not shown) specific to the anchor 136 so that all masking tools 108 may be positioned in a particular location on the mounting table 17. In other words, a particular location on the mounting table 17 may be chosen for securing masking tools 108 that are designed to coat only the vanes 112 of the doublet vane assembly 110. The specific location on the mounting table 17 for mounting the masking tool 108 may allow for the coating of the vanes 112 to be substantially consistent for all doublet vane assemblies 110.

It is also contemplated that there may be multiple receptacles on the mounting table 17 configured to receive the anchor 136. In other words, the anchor 136 and the mounting table 17 may be configured so that the masking tool 108 is only securable to the mounting table 17 at one or more discreet locations.

In addition, the anchors 57, 84, and 106 may be configured so that they are not able to be secured to the mounting table 17 at the same location as the anchor 136. In other words, the locations at which the masking tool is securable to the mounting table may depend on the type of masking tool being used. Alternatively, the mounting table 17 may include universal receptacles that may receive the anchors for any type of masking tool.

The first and second casing parts 114, 116 may be secured together by way of a fastening device 138. The fastening device 138 illustrated in Fig. 6E may be in the form of a wire wrapped around a loop attached to a perimeter of the masking tool 108. The base 118 may be attached to the first casing part 114 using a similar fastening device 138. However, it should be understood that the fastening device 138 may be any type of device capable of securing the first and second casing parts 114, 116 and the base 118 together and may be, for example, a snap fit connection, one or more clips, one or more bolts, or any other fastening device, now known or hereinafter developed, capable of compressing the first and second casing parts 114, 116 against each other. It is further contemplated that the first and second casing parts 114, 116 and the base 118 may be fully separable. Alternatively, the first and second casing parts 114, 116 may be connected to each other by way of a hinge and may be pivoted between an open position and a closed position.

The side walls 124, 126 may have a length L2 between about 5 and about 10 cm (e.g., about 8 cm). The maximum height H4 of the combined first and second casing parts 114, 116 may be within a range of about 5 to about 15 cm (e.g., about 8 cm).

It is contemplated that each of the first and second casing parts 114, 116 and the base 118 may be a continuous unitary body.

Figs. 6D-6I illustrate a method for loading the doublet vane assembly 110 into the masking tool 108. As shown in Fig. 6D, the second casing part 116 (which acts as a "door" or removable cover) is opened. The second casing part 116 may remain attached to the first casing part 114 by way of the fastening device 138. Alternatively, the first and second casing parts 114, 116 may be attached to each other by way of a hinged connection or may be completely separable from each other.

As shown in Fig. 6E, the doublet vane assembly 110 may be loaded into the chamber in the first casing part 114 and mounted on the support 130. As discussed above, the doublet vane assembly 110 may be positioned so that the doublet vane assembly 110 is pressed against the side wall 128 and the vanes 112 are at least partially pushed through the openings 132 so that the vanes 112 prevent seepage of protective coating into the chamber in the first casing part 114 through the openings 132.

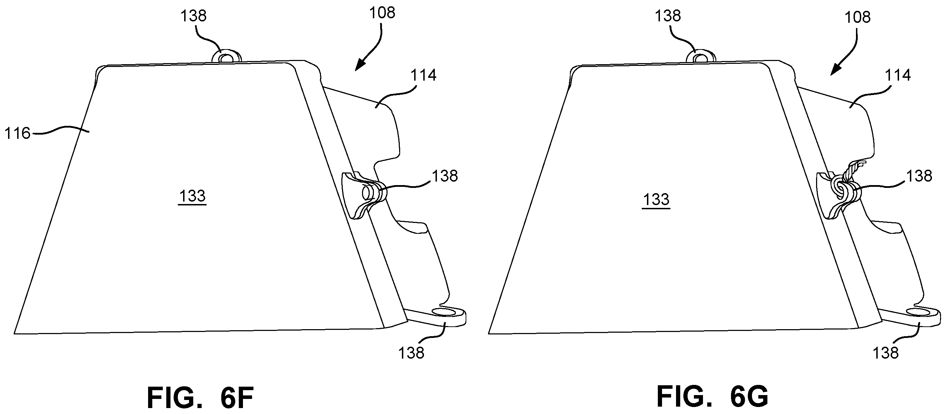

In Fig. 6F, the second casing part 116 is moved to a closed position in which the second casing part 116 covers the open end of the first casing part 114. In Fig. 6G, the first casing part 114 and the second casing part 116 are secured together by the fastening device 138. The fastening device 138 may be a wire tied around a loop. Alternatively, the first and second casing parts 114, 116 may be secured together by way of a snap fit connection, one or more clips, one or more bolts, or any other fastening device, now known or hereinafter developed, capable of compressing the first and second casing parts 114, 116 against each other. Alternatively, the first and second casing parts 114, 116 may be connected to each other by way of a hinge and may be pivoted between an open position and a closed position.

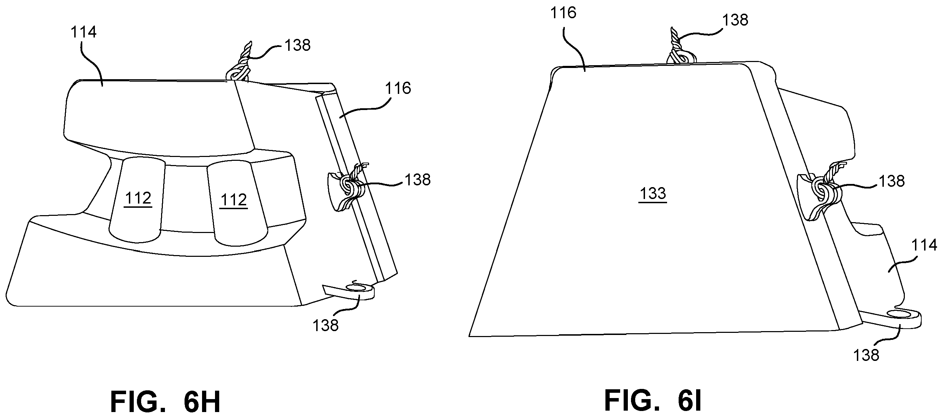

In Figs. 6H and 6I, the remaining fastening devices 138 also secure the first casing part 114 to the second casing part 116. The masking tool 108 may include any number of fastening device 138 as long as there are enough fastening device 138 to create a tight connection between the first casing part 114 and the second casing part 116 to prevent seepage of the protective coating into the internal chamber of the masking tool 108.

Once the first and second casing part 114, 116 are secured together, the first casing part 114 may be secured to the third base 118 by additional fastening devices 138.
While at least one exemplary embodiment of the present invention(s) is disclosed herein, it should be understood that modifications, substitutions and alternatives may be apparent to one of ordinary skill in the art and can be made without departing from the scope of this disclosure. This disclosure is intended to cover any adaptations or variations of the exemplary embodiment(s). In addition, in this disclosure, the terms "comprise" or "comprising" do not exclude other elements or steps, the terms "a" or "one" do not exclude a plural number, and the term "or" means either or both, unless this application states otherwise. Also, the terms "approximately", "about", and "substantially" encompass a range of plus or minus 15%. Furthermore, characteristics or steps which have been described may also be used in combination with other characteristics or steps and in any order unless the disclosure or context suggests otherwise.

Clauses:
Clause 1. A masking tool for a turbine component that is configured to receive and cover a portion of the turbine component, the masking tool comprising:
   a first casing part;
   a second casing part configured to engage the first casing part to form a chamber configured to receive a portion of the turbine component; and
   an anchor configured to secure the masking tool to a mounting table,
   wherein the masking tool is configured to leave part of the turbine component exposed to atmosphere when the first and second casing parts are secured together and receive the turbine component,
   wherein the first and second casing parts are configured to be compressed against each other when secured together,
   wherein the first and second casing parts are configured to seal a space containing portions of the turbine component without an elastomeric seal, and
   wherein an interior surface of the first casing part and an interior surface of the second casing part are contoured to match a contour of the turbine component.
Clause 2. The masking tool of clause 1, wherein the first and second casing parts have openings that allow a portion of the turbine component to be exposed to a surrounding environment while the first and second casing parts are secured together and receive the turbine component.
Clause 3. The masking tool of clause 2, wherein the turbine component includes a turbine blade, and further wherein, the portion of the turbine blade is a root pocket area.
Clause 4. The masking tool of clause 2, wherein the turbine component includes a turbine blade, and further wherein, the portion of the turbine blade is an airfoil portion.
Clause 5. The masking tool of clause 2, wherein the turbine component includes a turbine blade, and further wherein, the portion of the turbine blade is a plurality of vanes of a doublet vane assembly.
Clause 6. The masking tool of clause 1, wherein only the first casing part or the second casing part includes an opening configured to leave a portion of the turbine component exposed so that only a portion of one side of the turbine component remains exposed to atmosphere when enclosed within the masking tool.
Clause 7. The masking tool of clause 1, wherein a portion of the interior surface of the first casing part is convex and a portion of the interior surface of the second casing part is concave.
Clause 8. The masking tool of clause 1, wherein the first and second casing parts form a chamber that is open on a top side when the first and second casing parts are secured together.
Clause 9. The masking tool of clause 8, wherein the first and second casing parts are configured to form a cuboid shape with a part of the turbine component when the first and second casing parts are secured to each other and receive the turbine component.
Clause 10. A masking tool of clause 1 formed by way of a 3D printing process.
   wherein the chamber is exposed to atmosphere.
Clause 11. A protective coating system for applying a protective coating to a turbine component, the system comprising:
   a housing that encloses a chamber, the chamber being accessible by way of the opening of a door of the housing;
   a mounting table in the chamber; and
   the masking tool of clause 1,
   wherein the anchor of the masking tool is configured to be secured to the mounting table.
Clause 12. The system of clause 11, wherein the system is a physical vapor deposition (PVD) system utilizing a cathodic arc coating tool.
Clause 13. The system of clause 11, wherein the system is a low pressure plasma spray (LPPS) system.
Clause 14. A method of loading a turbine component into a masking tool for a protective coating system, the method comprising:
   separating or partially separating casing parts of the masking tool to open access to a holding chamber of the masking tool;
   inserting the turbine component into the chamber; and
   securing together the casing parts of the masking tool to create a tight fit between the casing parts of the masking tool and the turbine component that is substantially impermeable to the protective coating,
   wherein part of the turbine component remains uncovered after the casing parts of the masking tool are secured together, and
   wherein one or more interior surfaces of the casing parts is contoured to match a contour of the turbine component so that at least a part of the turbine component abuts against the one or more contoured interior surfaces.
Clause 15. The method of clause 14, wherein the coating impermeable tight fit between the casing parts is created without an elastomeric seal.
Clause 16. The method of clause 14, wherein the part of the turbine component that remains uncovered is a root pocket area.
Clause 17. The method of clause 14, wherein the part of the turbine component that remains uncovered is an airfoil portion.
Clause 18. The method of clause 14, wherein the turbine component is a doublet vane assembly and the parts of the turbine component that remains uncovered are the vanes.
Clause19. The method of clause 14, further comprising attaching an anchor to the first casing part of the casing parts, wherein the anchor secures the masking tool to a chamber floor in which coating material is deposited on the masking tool and the exposed portion of the turbine vane.
Clause 20. The method of clause 14, wherein the first and second casing parts are connected by a hinge.

## Claims

1. A method of loading a turbine component into a masking tool for a protective coating system, the method comprising:
separating or partially separating casing parts of the masking tool to open access to a holding chamber of the masking tool;
inserting the turbine component into the chamber; and
securing together the casing parts of the masking tool to create a tight fit between the casing parts of the masking tool and the turbine component that is substantially impermeable to the protective coating,
wherein part of the turbine component remains uncovered after the casing parts of the masking tool are secured together, and
wherein one or more interior surfaces of the casing parts is contoured to match a contour of the turbine component so that at least a part of the turbine component abuts against the one or more contoured interior surfaces.

2. The method of claim 1, further comprising creating the tight fit between the casing parts is created without an elastomeric seal.

3. The method of any one of claims 1 to 2, wherein the part of the turbine component that remains uncovered is a root pocket area.

4. The method of any one of claims 1 to 2, wherein the part of the turbine component that remains uncovered is an airfoil portion.

5. The method of any one of claims 1 to 2, wherein the turbine component is a doublet vane assembly and the parts of the turbine component that remains uncovered are the vanes.

6. The method of any one of claims 1 to 5, further comprising attaching an anchor to the first casing part of the casing parts, wherein the anchor secures the masking tool to a chamber floor in which coating material is deposited on the masking tool and the exposed portion of the turbine vane.

7. The method of any one of claims 1 to 6, wherein the first and second casing parts are connected by a hinge.

8. The method of any one of claims 1 to 7, wherein an interior-facing surface of the first casing part and/or an interior-facing surface of the second casing part comprises a plurality of alternating ridges and valleys arranged to correspond to ridges and valleys of a root portion of the turbine component.

9. The method of claim 8, further comprising positioning the ridges of the first and/or second casing part to engage the valleys of the root portion of the turbine components and positioning the valleys of the first and/or second casing part to engage the ridges of the root portion of the turbine component.

10. The method of any one of claims 1 to 9, further comprising securing the first casing part to the second casing part by way of a fastening device.

11. The method of claim 10, wherein the fastening device comprises at least one of a wire loop, a snap fit connection, one or more clips, and one or more bolts.

12. The method of any one of claims 1 to 11, further comprising leaving only part of one side of the turbine component exposed after the first and second casing parts of the masking tool are secured together.

13. The method of any one of claims 1 to 12, further comprising forming the first and second casing parts by way of a 3D printing process.

14. The method of any one of claims 1 to 13, wherein the contour of at least one of said one or more interior surfaces is convex.

15. The method of any one of claims 1 to 14, wherein the contour of at least one of said one or more interior surfaces is concave.
